# DEMANDE DE BREVET EUROPEEN

(11) **EP 3 909 806 A1**
(43) Date de publication de la demande: **17.11.2021**
(21) Numéro de dépôt: 21173214.4
(22) Date de dépôt: 11.05.2021
(51) Int. Cl.: B60L 53/30, B60L 53/14, B60L 3/12, B60L 50/60, G01R 27/00, G07C 5/08

(54) **SYSTÈME D'ALIMENTATION EN ÉNERGIE ÉLECTRIQUE D'UN VÉHICULE, NOTAMMENT FERROVIAIRE, ET PROCÉDÉ D'ALIMENTATION EN ÉNERGIE FERROVIAIRE INCLUANT UN TEL SYSTÈME**

(30) Priorité: 11.05.2020 FR 2004607
(71) Demandeur: ALSTOM Transport Technologies, 93400 Saint-Ouen-sur Seine (FR)
(72) Inventeur: MUSSET, Sebastien, 17220 Sainte Soulle (FR); VERGNIAUD, Romain, 17000 La Rochelle (FR); DUBAN, Patrick, 17000 La Rochelle (FR); RENIE, Matthieu, 17139 Dompierre Sur Mer (FR)
(74) Mandataire: Lavoix

(57) **Abrégé**

Ce système (4) d'alimentation en énergie électrique d'un véhicule (2) se déplaçant sur une voie (3) comprend des éléments de stockage d'énergie (42) ; des points de recharge (46) proches de la voie, alimentés par une infrastructure (44) fournissant un courant de charge ; un organe de captation (48) porté par le véhicule et relié à l'élément de stockage et aux points de recharge, permettant de transmettre le courant de charge à l'élément de stockage d'énergie ; des moyens de mesure (56) d'une grandeur caractéristique de la qualité du contact entre l'organe de captation et les points de recharge ; et un contrôleur (50), propre à analyser cette grandeur caractéristique. Selon l'invention, la grandeur caractéristique que le contrôleur est propre à analyser est une grandeur électrique, et le contrôleur est propre à adapter l'opération de charge en fonction de cette grandeur caractéristique.

## Description

La présente invention concerne un système d'alimentation en énergie électrique d'un véhicule, notamment ferroviaire. L'invention concerne également un procédé d'alimentation en énergie électrique d'un véhicule, notamment ferroviaire.

Les véhicules de transport en commun électriques, par exemple ferroviaires, comme les tramways, sont munis d'éléments de stockage d'énergie, tels que des batteries ou des super-condensateurs fournissant au tramway l'énergie nécessaire à ses déplacements. Afin de permettre d'effectuer toute la longueur d'un trajet, les éléments de stockage d'énergie doivent être rechargés durant le voyage. Cette recharge est effectuée en transmettant un courant, d'une infrastructure d'alimentation, par un point de recharge de cette infrastructure d'alimentation, à un organe de captation, par exemple un patin, appartenant au tramway. Afin que la recharge soit rapide, le courant circulant dans le point de recharge et dans l'organe de captation est très élevé, par exemple 1600 A.

Ainsi, s'il y a un mauvais contact entre l'organe de captation et le point de recharge, par exemple si l'un ou l'autre est détérioré, il peut y avoir création d'un arc électrique entre l'organe de captation et le point de recharge. L'apparition d'un tel arc peut créer une soudure entre l'organe de captation et le point de recharge. Ces détériorations pouvant aller jusqu'à déclencher un incendie, il est nécessaire de contrôler la qualité du contact entre l'organe de captation et le point de recharge pour pouvoir effectuer des opérations de maintenance préventives et, ainsi, éviter tout accident.

CN 108177530 A divulgue un dispositif d'évaluation de la qualité du contact entre un patin et un rail. A cet effet, le dispositif de détection est propre à détecter un arc électrique par le biais d'un détecteur d'ultra-violets. De plus, des capteurs de pression permettent d'évaluer, à tout instant, la pression entre le patin et le rail. La combinaison des données de pression et de la détection d'arc permettent de situer le ou les défauts sur le patin et/ou le rail à l'origine d'un arc électrique. Ce dispositif permet donc de prévoir des opérations de maintenance après détection d'un arc électrique pour éviter toute répétition de ce phénomène, et donc toute faille de sécurité.

Cependant, ce dispositif ne permet pas de détecter un défaut de qualité de contact entre le point de recharge et le patin avant que l'arc électrique n'apparaisse. En effet, le système ne permet que de détecter un arc électrique et de situer les organes détériorés après l'apparition de l'arc. De plus, ce dispositif ne prévoit pas de solution pour continuer à utiliser les organes défectueux en toute sécurité en attendant l'opération de maintenance.

C'est à ces inconvénients qu'entend plus particulièrement remédier l'invention en proposant un système d'alimentation en énergie électrique d'un véhicule ferroviaire plus efficace.

A cet effet, l'invention a pour objet un système d'alimentation en énergie électrique d'un véhicule se déplaçant sur une voie, le système comprenant :
- des éléments de stockage d'énergie portés par le véhicule ;
- des points de recharge disposés à proximité de la voie ;
- une infrastructure d'alimentation du ou de chaque point de recharge, disposée au sol et propre à fournir au ou à l'un des points de recharge un courant de charge ;
- un organe de captation porté par le véhicule et relié à l'élément de stockage d'énergie, l'organe de captation et l'un des points de recharge étant propres à coopérer pour transmettre le courant de charge, lors d'une opération de charge, à l'élément de stockage d'énergie ;
- des moyens de mesure d'au moins une grandeur caractéristique de la qualité du contact entre l'organe de captation et le ou chaque point de recharge ; et
- un contrôleur, propre à analyser au moins une grandeur caractéristique de la qualité du contact entre l'organe de captation et le ou chaque point de recharge, fournie par les moyens de mesure,
caractérisé en ce que ladite au moins une grandeur caractéristique que le contrôleur est propre à analyser est une grandeur électrique,
et en ce que le contrôleur est propre à adapter l'opération de charge en fonction de la dite grandeur caractéristique.

Grâce à l'invention, l'opération de charge est adaptée en fonction de la qualité du contact entre l'organe de captation et le point de recharge. Cela permet, lorsque le contact est mauvais et risque d'induire un arc électrique, de prévoir des opérations de maintenance préventive et une utilisation différente de l'organe de captation afin d'éviter l'apparition de l'arc électrique. Si un arc électrique est détecté, le dispositif permet de continuer à utiliser le véhicule sans risquer un incendie.

Selon des aspects avantageux mais non obligatoires de l'invention, un tel système comporte une ou plusieurs des caractéristiques suivantes prises selon toutes combinaisons techniquement admissibles :
- La grandeur électrique est choisie dans le groupe consistant en une résistance de contact entre l'organe de captation et le ou l'un des points de recharge, une variation temporelle de tension entre l'organe de captation et une masse, appartenant à l'infrastructure d'alimentation, et une variation temporelle de tension entre l'un des points de recharge et la masse.
- Le contrôleur est propre à comparer ladite au moins une grandeur électrique à au moins une valeur seuil prédéfinie.
- Ladite au moins une grandeur électrique est la résistance de contact entre l'organe de captation et l'un des points de recharge et les moyens de mesure sont propres à acquérir la tension entre l'un des points de recharge et l'organe de captation.
- Le contrôleur est propre à calculer, en divisant une valeur de la tension entre l'organe de captation et l'un des points de recharge par une valeur de l'intensité du courant de charge, une valeur de la résistance entre l'organe de captation et l'un des points de recharge.
- Le contrôleur est propre à commander l'opération de charge selon une loi de commande en fonction de ladite grandeur caractéristique, la loi de commande étant la suivante :
   si la valeur calculée de la résistance est inférieure à un premier seuil, fixer la valeur de l'intensité du courant de charge à une valeur maximale prédéfinie ;
   si la valeur calculée de la résistance est supérieure au premier seuil et inférieure à un deuxième seuil, fixer la valeur de l'intensité du courant de charge à une valeur inférieure à la valeur maximale ; et
   si la valeur calculée de la résistance est supérieure à un deuxième seuil, fixer la valeur de l'intensité du courant de charge à une valeur minimum prédéfinie.
- Le système comporte des moyens de mesure propres à mesurer la tension entre l'organe de captation et la masse ou des moyens de mesure propres à mesurer la tension entre le ou l'un des points de recharge et la masse, la grandeur étant la variation temporelle de la tension mesurée.
- Le contrôleur est propre à comparer les valeurs mesurées de la variation temporelle de tension à au moins une valeur seuil.
- Le contrôleur est propre à commander l'opération de charge selon une loi de commande en fonction de ladite grandeur caractéristique, la loi de commande étant la suivante : assurer la charge avec un courant de charge seulement si la valeur mesurée de la variation temporelle de tension entre le patin et la masse est inférieure à un premier seuil.

Selon un autre aspect, l'invention a également pour objet un procédé d'alimentation en énergie électrique d'un véhicule, à l'aide du système d'alimentation en énergie électrique d'un véhicule, le système étant tel que défini ci-dessus, la méthode comprenant les étapes suivantes, consistant à :
a) acquérir, à l'aide des moyens de mesure, ladite au moins une grandeur caractéristique ;
b) analyser ladite grandeur caractéristique acquise, à l'aide du contrôleur ; et
c) adapter, à l'aide du contrôleur, l'opération de charge selon la loi de commande en fonction de ladite grandeur caractéristique.

Ce procédé induit les mêmes avantages que ceux mentionnés ci-dessus au sujet du système de contrôle de l'alimentation en énergie électrique d'un véhicule de transport en commun.

L'invention sera mieux comprise et d'autres avantages de celle-ci apparaîtront plus clairement à la lumière de la description qui va suivre de deux modes de réalisation d'un système d'alimentation en énergie électrique d'un véhicule ferroviaire et d'un procédé d'alimentation en énergie électrique d'un véhicule ferroviaire, donnée uniquement à titre d'exemple et faite en référence aux dessins, dans lesquels :
[Fig 1] la figure 1 est une vue schématique de côté d'un véhicule de transport en commun muni d'un système d'alimentation en énergie électrique d'un véhicule ferroviaire selon un premier mode de réalisation de l'invention ; et
[Fig 2] la figure 2 est une vue schématique de côté d'un véhicule de transport en commun muni d'un système d'alimentation en énergie électrique d'un véhicule ferroviaire selon un deuxième mode de réalisation de l'invention.

Le véhicule ferroviaire 2 présenté dans les figures est un tramway se déplaçant sur une voie 3 formée de files de rails.

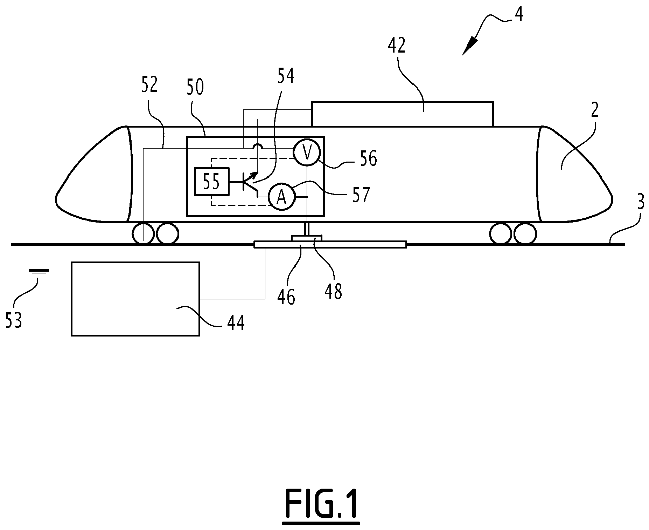

Le véhicule 2 présenté sur la figure 1 est muni d'un système 4 d'alimentation en énergie électrique du véhicule 2, selon un premier mode de réalisation.

Le système 4 comprend un élément de stockage d'énergie 42, qui peut être une batterie ou un super-condensateur, porté par le véhicule 2. Dans l'exemple de la figure 1, l'élément de stockage 42 est situé sur le toit du véhicule 2.

Une infrastructure d'alimentation 44 appartenant au système 4 est disposée au sol et est destinée à recharger l'élément de stockage 42.

Le système 4 comprend également un point de recharge 46, disposé à proximité de la voie 3, par exemple entre ses rails, et relié à l'infrastructure d'alimentation 44, ainsi qu'un organe de captation 48 porté par le véhicule. L'organe de captation 48 est un patin ou en variante un pantographe. Le patin 48 est propre à coopérer avec le point de recharge 46 pour transmettre, pendant une opération de charge, un courant de charge fourni par l'infrastructure d'alimentation 44 à l'élément de stockage 42. Une valeur de l'intensité du courant de charge est prédéterminée par un utilisateur ou par des moyens de contrôle, non représentés, appartenant à l'infrastructure d'alimentation 44.

En pratique, le véhicule 2 comprend plusieurs patins 48, par exemple deux, trois ou six, chacun des patins 48 étant associé à un identifiant unique. Un seul des patins 48 est utilisé à la fois pour être mis en contact avec le point de recharge 46.

La voie 3 dispose de plusieurs points de recharge 46, chaque point de recharge 46 étant associé à un identifiant unique, pour pouvoir recharger l'élément de stockage 42 tout au long du voyage, un unique point de recharge 46 étant utilisé à la fois par le véhicule 2.

Le patin 48 est relié, par le biais d'un contrôleur 50, à l'élément de stockage 42 et le contrôleur 50 est relié, par le biais d'un retour de courant 52, à une masse 53, appartenant à l'infrastructure d'alimentation 44. La masse 53 est formée avantageusement des rails de la voie 3.

Le contrôleur 50 comporte des moyens de régulation de la charge 54 propres à commander l'intensité du courant fourni à l'élément de stockage 42 depuis le patin 48. Il comporte des moyens 55 de commande des moyens de régulation 54, lesquels sont reliés à des moyens 56 de mesure de la tension entre le patin 48 et la masse 53 et des moyens 57 de mesure de l'intensité du courant circulant du patin 48 à l'élément de stockage 42.

Les moyens de commande 55 comportent des moyens de calcul d'une grandeur caractéristique du contact telle que la résistance de contact entre le patin 48 et le point de recharge 46 et des moyens de définition d'une intensité de charge pour la commande des moyens de régulation 54 en fonction de la valeur de la résistance de contact entre le patin 48 et le point de recharge 46.

Le contrôleur 50 comprend également une mémoire, non représentée sur les figures, pour mémoriser la tension acquise par les moyens de mesure 56 et l'intensité mesurée par les moyens de mesure 57. Le contrôleur 50 est également pourvu de moyens de communication non représentés pour communiquer avec un utilisateur par le biais, par exemple, d'une interface de communication.

Lors de l'opération de charge, l'infrastructure d'alimentation 44 fournit le courant de charge, qui est transmis au point de recharge 46.

Le courant est ensuite capté par l'organe de captation 48 qui est en contact avec le point de recharge 46.

Dans le cas où le contact entre le point de recharge 46 et le patin 48 est de mauvaise qualité, une résistance de contact entre le patin 48 et le point de recharge 46 augmente.

Les moyens de mesure 56 et 57 déterminent une valeur de la tension entre le patin 48 et la masse 53 et de l'intensité circulant entre le patin 48 et l'élément de stockage 42. Le contrôleur 50 en déduit une grandeur électrique caractéristique intégrant la valeur de la résistance de contact entre le patin 48 et le point de recharge 46.

Pour cette analyse et avant la recharge de l'élément de stockage 42, l'infrastructure 44 injecte un courant de test dans le point de recharge 46, alors que les moyens de régulation 54 sont passants. Ce courant de test est ensuite capté par le patin 48 pour passer par les moyens de régulation 54 et aller jusqu'à l'élément de stockage 42. La tension présente entre le patin 48 et la masse 53 est alors mesurée par les moyens de mesure 56, l'intensité du courant étant connue ou mesurée par les moyens de mesure 57, la valeur de la résistance entre le point de recharge 46 et le patin 48 est calculée par le contrôleur 50 comme étant la différence entre la tension fournie par l'infrastructure d'alimentation 44, connue des moyens de commande 55, et la tension mesurée par les moyens de mesure 56, cette différence étant divisée par la valeur de l'intensité mesurée par les moyens de mesure 57. Cette valeur est ensuite comparée par le contrôleur 50 à des valeurs seuil prédéfinies afin de déterminer la qualité du contact entre le point de recharge 46 et le patin 48 et ainsi commander l'opération de charge selon une loi de commande.

Si la valeur calculée de la résistance est inférieure à un premier seuil, par exemple 3 µΩ, le contrôleur 50 modifie la valeur de l'intensité du courant de charge à une valeur maximale prédéfinie, par exemple 1600 A. En effet, lorsque la résistance entre le patin 48 et le point de recharge 46 est faible, cela signifie que le contact entre les deux est bon, et que le risque d'apparition d'un arc électrique est faible.

Si la valeur calculée de la résistance est supérieure au premier seuil et inférieure à un deuxième seuil, par exemple 30 µΩ, le contrôleur 50 envoie, grâce aux moyens de communication, d'une part un avertissement à l'utilisateur, pour planifier une opération de maintenance, et d'autre part, une commande pour changer de patin 48. Si cette opération de changement de patin 48 n'est pas possible parce que le véhicule 2 n'a pas d'autre patin 48 en bon état disponible, le contrôleur 50 fixe la valeur de l'intensité du courant de charge à une valeur inférieure à la valeur maximale prédéfinie. Par exemple, la réduction de la valeur de l'intensité du courant de charge par rapport à la valeur maximale prédéfinie est inversement proportionnelle à la valeur calculée de la résistance. En pratique, la valeur de l'intensité du courant de charge ne descend pas en-dessous de 200 A.

Si la valeur calculée de la résistance est supérieure au deuxième seuil, le contrôleur 50 envoie un avertissement à l'utilisateur pour planifier une opération de maintenance et envoie une commande pour changer de patin 48. Si cette opération de changement de patin 48 n'est pas possible parce que le véhicule 2 n'a pas d'autre patin 48 en bon état disponible, le contrôleur 50 envoie une commande pour changer de point de recharge 46 et passer au point de recharge 46 suivant. Pour pouvoir effectuer cette action, l'élément de stockage42 doit être assez chargé pour que le véhicule 2 puisse se déplacer jusqu'au point de recharge 46 suivant. Si ce n'est pas le cas, le contrôleur 50 modifie l'intensité du courant de charge à une valeur minimale prédéfinie, par exemple 200 A.

La valeur calculée de la résistance est sauvegardée dans la mémoire du contrôleur 50. L'identifiant du patin 48 et du point de recharge 46 sont également stockés en mémoire et associés à la valeur de la résistance calculée. L'historique de valeurs ainsi formé permet, au moment d'effectuer l'opération de maintenance, de savoir quels points de recharge 46 et quels patins 48 sont défectueux.

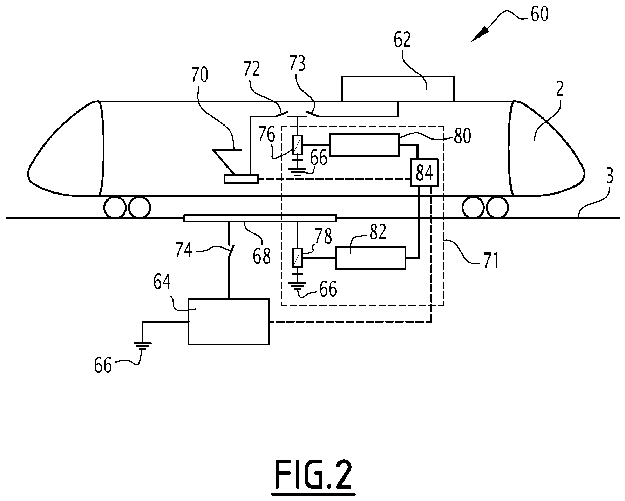

Un deuxième mode de réalisation du système 4 d'alimentation en énergie électrique du véhicule 2, référencé 60, est présenté à la figure 2. Dans ce mode de réalisation, le véhicule 2 et la voie 3 sont identiques à ceux du premier mode de réalisation et gardent les mêmes références.

Dans ce mode de réalisation, le système 60 comprend un élément de stockage 62, identique à l'élément de stockage 42, une infrastructure d'alimentation 64, similaire à l'infrastructure d'alimentation 44 et une masse 66, identique à la masse 53.

Le système 60 comprend également un point de recharge 68, identique au point de recharge 46 et un patin 70 identique au patin 48.

En outre, le système 60 comprend un contrôleur 71, représenté en pointillés sur la figure 2, réparti entre le sol et le véhicule 2. Il commande un premier contacteur 72 ainsi qu'un disjoncteur 73, disposés en série et propres à relier, lorsqu'ils sont tous les deux fermés, le patin 70 à l'élément de stockage 62. Il comporte en outre un deuxième contacteur 74 propre à relier l'infrastructure d'alimentation 64 au point de recharge 68.

Le contrôleur 71 comprend des moyens de mesure 76 propres à mesurer une valeur d'une variation temporelle de tension entre le patin 70 et la masse 66. Les moyens de mesure 76 formés d'une résistance sont connectés entre le contacteur 72 et le disjoncteur 73 d'une part et la masse d'autre part. Ils sont ainsi reliés, d'une part, au patin 70 lorsque le contacteur 72 est fermé et, d'autre part, à la masse 66.

Le contrôleur 71 comprend également des moyens de mesure 78 propres à mesurer une valeur d'une variation temporelle de tension entre le point de recharge 68 et la masse 66. Les moyens de mesure 76, formés d'une résistance, sont reliés, d'une part, au point de recharge 68 et, d'autre part, à la masse 66.

Le contrôleur 71 comprend également un premier système de détection 80 embarqué dans le véhicule auquel sont reliés les moyens de mesure 76. Le système de détection 80 est destiné à traiter les informations reçues par les moyens de mesure 76.

Le contrôleur 71 comprend également un deuxième système de détection 82 au sol relié aux moyens de mesure 78 et destiné à traiter les informations reçues par les moyens de mesure 78.

En outre, le contrôleur 71 comprend des moyens de commande 84 propres à commander le rapprochement entre le patin 70 et le point de recharge 68 et propres à moduler l'intensité du courant fourni par l'infrastructure d'alimentation 64. Le moyen de commande 84 assurent également la commande des contacteurs 72, 74 et du disjoncteur 73. Le contrôleur 71 comprend également des moyens de communication, non représentés sur les figures,

Sur la figure 2, le patin 70 n'est pas en contact avec le point de recharge 68. Dans cette configuration, le contacteur 72 est ouvert, ainsi que le contacteur 74 et le disjoncteur 73. Le patin 70 est mis en contact avec le point de recharge 68 par un ordre des moyens de commande 84. Ensuite, ou simultanément au déploiement du patin 70, les moyens de commande 84 envoient un ordre de fermeture au contacteur 74, reliant le point de recharge 68 à l'infrastructure d'alimentation 64.

Si le système de détection 82 détecte une tension, alors cela signifie que le point de recharge 68 est alimenté. Dans ce cas, le système de détection transmet l'information aux moyens de commande 84 qui envoient un ordre de fermeture du contacteur 72.

Le disjoncteur 73 est alors fermé. En pratique, le disjoncteur 73 peut être fermé avant que le patin 70 soit mis en contact avec le point de recharge 68.

Si le système de détection 80, associé au patin 70, reçoit des moyens de mesure 76, lors de l'opération de charge, un signal de variation temporelle de tension, entre le patin 70 et la masse 66, supérieur à une valeur maximale prédéfinie, par exemple 300 V/10ms, les moyens de commande 84 commandent l'ouverture du disjoncteur 73 pour arrêter l'opération de charge et envoie un ordre d'utiliser un autre patin 70 pour redémarrer l'opération de charge.

De même, si le système de détection 82, associé au point de recharge 68, reçoit, des moyens de commande 78, un signal de variation temporelle de tension, entre le point de recharge 68 et la masse 66, supérieur à la valeur maximale prédéfinie, les moyens de commande 84 commandent l'ouverture du disjoncteur 73 pour arrêter l'opération de charge et envoie un ordre d'utiliser un autre point de recharge 68 pour redémarrer l'opération de charge.

En variante, soit les moyens de mesure 76 et le système de détection 80, soit les moyens de mesure 78 et les systèmes de détection 82 sont supprimés.

Pour les deux modes de réalisation, un procédé d'alimentation en énergie électrique du véhicule 2, à l'aide du système 4 ou 60, consiste à acquérir avec les moyens de mesure 56 ou 76 et 78 une grandeur électrique. Ensuite, cette ou ces grandeurs sont comparées par le contrôleur 50 ou 71 à la première valeur seuil et à la deuxième valeur seuil ou à la valeur maximale prédéfinie de variation temporelle de tension. Finalement, l'opération de charge est adaptée par le contrôleur 50 ou 71 selon la loi de commande, en fonction de la comparaison effectuée précédemment.

En variante, la mesure de la résistance entre le patin 48 et le point de recharge 46 est faite de manière continue, et non ponctuellement.

Selon une autre variante, les points de recharge 46 ou 68 sont des caténaires rigides situés au-dessus de la voie 3.

En variante, le contrôleur 50 initie une opération de charge de l'élément de stockage 42 à basse intensité et effectue une analyse de la valeur de la résistance de contact entre le patin 48 et le point de recharge 46.

## Revendications

1. Système (4 ; 6) d'alimentation en énergie électrique d'un véhicule (2) se déplaçant sur une voie (3), le système comprenant :
- des éléments de stockage d'énergie (42 ; 62) portés par le véhicule ;
- des points de recharge (46 ; 68) disposés à proximité de la voie (3) ;
- une infrastructure d'alimentation (44 ; 64) du ou de chaque point de recharge, disposée au sol et propre à fournir au ou à l'un des points de recharge un courant de charge ;
- un organe de captation (48 ; 70) porté par le véhicule et relié à l'élément de stockage d'énergie, l'organe de captation et l'un des points de recharge étant propres à coopérer pour transmettre le courant de charge, lors d'une opération de charge, à l'élément de stockage d'énergie ;
- des moyens de mesure (56 ; 76, 78) d'au moins une grandeur caractéristique de la qualité du contact entre l'organe de captation et le ou chaque point de recharge ; et
- un contrôleur (50; 71), propre à analyser au moins une grandeur caractéristique de la qualité du contact entre l'organe de captation et le ou chaque point de recharge, fournie par les moyens de mesure,
**caractérisé en ce que** ladite au moins une grandeur caractéristique que le contrôleur est propre à analyser est une grandeur électrique,
et **en ce que** le contrôleur est propre à adapter l'opération de charge en fonction de la dite grandeur caractéristique.

2. Système (4 ; 6) d'alimentation selon la revendication 1, dans lequel la grandeur électrique est choisie dans le groupe consistant en une résistance de contact entre l'organe de captation (48 ; 70) et le ou l'un des points de recharge (46 : 68), une variation temporelle de tension entre l'organe de captation (70) et une masse (53 ; 66), appartenant à l'infrastructure d'alimentation (44 ; 64), et une variation temporelle de tension entre l'un des points de recharge (68) et la masse (66).

3. Système (4 ; 6) d'alimentation selon la revendication 1 ou 2, dans lequel le contrôleur (50 ; 71) est propre à comparer ladite au moins une grandeur électrique à au moins une valeur seuil prédéfinie.

4. Système (4) d'alimentation selon la revendication 2 ou 3, dans lequel ladite au moins une grandeur électrique est la résistance de contact entre l'organe de captation (48) et l'un des points de recharge (46) et les moyens de mesure (56) sont propres à acquérir la tension entre l'un des points de recharge (46) et l'organe de captation (48).

5. Système (4) d'alimentation selon la revendication 4, dans lequel le contrôleur (50) est propre à :
- calculer, en divisant une valeur de la tension entre l'organe de captation (48) et l'un des points de recharge (46) par une valeur de l'intensité du courant de charge, une valeur de la résistance entre l'organe de captation (48) et l'un des points de recharge (46) .

6. Système (4) d'alimentation selon la revendication 4 ou 5, dans lequel le contrôleur est propre à commander l'opération de charge selon une loi de commande en fonction de ladite grandeur caractéristique, la loi de commande étant la suivante :
- si la valeur calculée de la résistance est inférieure à un premier seuil, fixer la valeur de l'intensité du courant de charge à une valeur maximale prédéfinie ;
- si la valeur calculée de la résistance est supérieure au premier seuil et inférieure à un deuxième seuil, fixer la valeur de l'intensité du courant de charge à une valeur inférieure à la valeur maximale ; et
- si la valeur calculée de la résistance est supérieure à un deuxième seuil, fixer la valeur de l'intensité du courant de charge à une valeur minimum prédéfinie.

7. Système (6) d'alimentation selon la revendication 2 ou 3, dans lequel le système comporte des moyens de mesure (76) propres à mesurer la tension entre l'organe de captation (70) et la masse (66) ou des moyens de mesure (78) propres à mesurer la tension entre le ou l'un des points de recharge (68) et la masse, la grandeur étant la variation temporelle de la tension mesurée.

8. Système (6) d'alimentation selon la revendication 7, dans lequel le contrôleur (71) est propre à comparer les valeurs mesurées de la variation temporelle de tension à au moins une valeur seuil.

9. Système (6) d'alimentation selon la revendication 8, dans lequel le contrôleur est propre à commander l'opération de charge selon une loi de commande en fonction de la dite grandeur caractéristique, la loi de commande étant la suivante :
- assurer la charge avec un courant de charge seulement si la valeur mesurée de la variation temporelle de tension entre l'organe de captation (70) et la masse (66) est inférieure à un premier seuil.

10. Procédé d'alimentation en énergie électrique d'un véhicule (2), à l'aide du système (4 ; 6) d'alimentation en énergie électrique d'un véhicule, le système étant selon l'une quelconque des revendications précédentes, la méthode comprenant les étapes suivantes, consistant à :
- a) acquérir, à l'aide des moyens de mesure (56 ; 78, 80), ladite au moins une grandeur caractéristique ;
- b) analyser ladite grandeur caractéristique acquise, à l'aide du contrôleur (50 ; 71) ; et
- c) adapter, à l'aide du contrôleur, l'opération de charge en fonction de ladite grandeur caractéristique.
